# EUROPÄISCHE PATENTSCHRIFT

(11) **EP 2 238 461 B1**
(45) Veröffentlichungstag und Bekanntmachung des Hinweises auf die Patenterteilung: **04.07.2012**
(21) Anmeldenummer: 09704390.5
(22) Anmeldetag: 19.01.2009
(51) Int. Cl.: G01R 1/073, G01R 31/28

(54) **MODUL FÜR EINEN PARALLELTESTER ZUM PRÜFEN VON LEITERPLATTEN**
MODULE FOR A PARALLEL TESTER FOR TESTING OF CIRCUIT BOARDS
MODULE POUR UN TESTEUR PARALLÈLE CONÇU POUR TESTER DES CARTES DE CIRCUIT IMPRIMÉ

(30) Priorität: 25.01.2008 DE 102008006130
(43) Veröffentlichungstag der Anmeldung: 13.10.2010
(73) Patentinhaber: DTG International GmbH, 8005 Zürich (CH)
(72) Erfinder: DEHMEL, Rüdiger, 31515 Wunstorf (DE); GÜLZOW, Andreas, 31832 Springe (DE); HOLZBRECHER, Michael, 31515 Wunstorf (DE); BRUCHWALD, Edward, 31515 Wunstorf (DE)
(74) Vertreter: Ganahl, Bernhard
(86) Internationale Anmeldenummer: PCT/EP2009/050561
(87) Internationale Veröffentlichungsnummer: WO 2009/092694

(56) Entgegenhaltungen:
- EP-A- 0 108 405
- EP-A- 0 406 919
- US-A- 4 465 972
- US-A- 4 674 006
- US-A- 4 939 454
- US-A- 5 485 096
- US-A1- 2008 068 034

## Beschreibung

Die vorliegende Erfindung betrifft ein Modul für einen Paralleltester zum Prüfen von Leiterplatten sowie einen Paralleltester zum Prüfen von Leiterplatten. Insbesondere betrifft die vorliegende Erfindung ein Modul für einen Paralleltester zum Prüfen von unbestückten Leiterplatten sowie einen Paralleltester zum Prüfen von unbestückten Leiterplatten

Vorrichtungen zum Prüfen von elektrischen Leiterplatten sind bspw. aus der US 3,564,408 bzw. der US 4,417,204 bekannt. Diese Vorrichtungen weisen eine Kontaktplatte auf, an der Prüfstifte in einem Grundraster angeordnet sind. Die Prüfstifte sind über lange Kabel mit einer Prüfschaltung verbunden. Die zu prüfenden Leiterplatten werden auf die Prüfplatte aufgelegt, wobei ein Adapter zwischen der Leiterplatte und der Prüfplatte angeordnet sein kann, so dass zwischen jedem Prüfpunkt der zu prüfenden Leiterplatte und einem Prüfstift ein elektrischer Kontakt hergestellt wird.

Ausgehend von dieser Art von Prüfvorrichtungen wurden modular aufgebaute Prüfvorrichtungen entwickelt, wie sie in den Patenten DE 32 40 916 C2 und DE 33 40 180 C1 beschrieben sind. Diese Art von Prüfvorrichtungen weisen eine Grundplatte auf, auf der vertikal angeordnete Module lagern, die jeweils einen Teil der elektronischen Prüfschaltung umfassen und an ihrem oberen Ende vertikal ausgerichtete Prüfstifte aufweisen. In einer Prüfvorrichtung werden mehrere derartige Module nebeneinander angeordnet, wobei die Anordnung der Prüfstifte ein die Kontaktplatte ersetzendes Kontaktfeld bildet. Für einen guten Zusammenhalt der Module kann eine Lochplatte auf die Prüfstifte aufgesetzt werden, wobei jeder Prüfstift ein Loch in der Lochplatte durchsetzt und so in seiner Lage fixiert ist.

Dieser modulare Aufbau des Kontaktfeldes hat sich sehr bewährt und in der Praxis durchgesetzt. Ein wesentlicher Vorteil dieses modularen Aufbaus ist, dass der Kontaktdruck, der beim Prüfen einer Leiterplatte angelegt wird, über die Module an die Grundplatte weitergeleitet wird.

Aus dem Gebrauchsmuster DE 88 06 064 U1 ist eine weitere Prüfvorrichtung bekannt, bei der das Kontaktfeld modular ausgebildet ist. Diese Module sind streifenförmig ausgebildet mit zum Beispiel je vier Reihen quadratischer Pads bzw. Kontaktflächen. Es ist hierin offenbart, dass die Pads in einem Raster mit einem Rastermaß von beispielsweise 0,5 - 2 mm angeordnet sind. Diese Module mit einer derart dichten Anordnung von Pads haben sich in der Praxis nicht durchgesetzt, da sie zum einen wegen der hohen Anzahl von Kontaktstellen nur von einer sehr großen und damit teuren Auswertelektronik ausgelesen werden können und zum anderen hat die im Gebrauchsmuster DE 88 06 064 beschriebene Ausführungsform mit einer vertikal gestellten Leiterplatte, an deren Stirnseite unmittelbar die Kontaktflächen ausgebildet sind, in der Serienproduktion erhebliche Probleme bereitet.

Aus der EP 0 875 767 A2 geht eine Prüfvorrichtung hervor, die mit einer eine Anzahl von Testanschlüssen aufweisenden Auswerteelektronik versehen ist. Diese Prüfvorrichtung weist ein aus einer mehrlagigen Leiterplatte ausgebildetes Grundraster auf, das an der Oberseite in einem Raster angeordnete Kontaktstellen besitzt. Mehrere dieser Kontaktstellen sind mittels in der Leiterplatte des Grundrasters verlaufender Scankanäle elektrisch miteinander verbunden. Auf dem Grundraster lagert ein Adapter und/oder ein Translator, auf welche eine zu testende Leiterplatte aufgelegt werden kann. Der Adapter und/oder Translator stellt einen elektrischen Kontakt von auf der Leiterplatte befindlichen Leiterplattentestpunkten zu den Kontaktstellen des Grundrasters her.

Die WO 02/31516 bzw. die EP 1 322 967 B1 offenbaren ein weiteres Modul für eine Prüfvorrichtung zum Tes-ten von Leiterplatten, das einen streifenförmigen Abschnitt mit Kontaktstellen auf-weist, der einen Teil eines Grundrasters der Prüfvorrichtung bildet. Unterhalb des streifenförmigen Abschnittes ist eine vertikal stehende Platte angeordnet, auf welcher ein Teil einer Auswerteelektronik zum Auswerten von Prüfsignalen angeordnet ist. Die Kontaktstellen auf dem streifenförmigen Abschnitt sind in einem Raster mit einem Rasterabschlag von nicht mehr als 2 mm angeordnet und zumindest zwei Kontaktstellen eines Moduls sind derart elektrisch miteinander verbunden, dass die elektrisch verbundenen Kontaktstellen mit einem einzigen Eingang einer Elektronikeinheit in Kontakt stehen.

In der EP 1 083 434 A2 bzw. der US 6,445,173 B1 ist eine weitere Vorrichtung zum Prüfen von Leiterplatten beschrieben, bei welcher das Grundraster aus zur Ebene des Grundrasters senkrecht stehenden Leiterplatten ausgebildet ist. Diese Leiterplatten, die als Grundrasterleiterplatten bezeichnet werden, weisen an den in der Ebene des Grundrasters liegenden Schmalseitenflächen Kontaktpunkte auf, die die Kontaktelemente des Grundrasters darstellen. Diese Kontaktpunkte sind mit Leiterbahnen verbunden, die sich über eine Seitenfläche der Grundrasterleiterplatten erstrecken. Diese Grundrasterleiterplatten sind als mehrlagige Leiterplatten ausgebildet, wobei in unterschiedlichen Lagen zueinander quer verlaufende Leiterbahnen angeordnet sind, die eine Matrix ausbilden. An den Kreuzungspunkten dieser quer zueinander verlaufenden Leiterbahnen können diese mittels einer Durchkontaktierung elektrisch verbunden werden. Mit diesen Durchkontaktierungen und der Matrix können ausgewählte Kontaktstellen des Grundrasters elektrisch miteinander verbunden werden, so dass die miteinander verbundenen Kontaktstellen lediglich einen einzigen Anschluss an eine Auswerteelektronik benötigen. Da die Leiterbahnen dieser Matrix über eine größere Fläche der Grundrasterleiterplatten verteilt sind, ist deren Ausgestaltung wesentlich einfacher als die Scankanäle, die aus der oben erläuterten EP 0 875 767 A2 bekannt sind.

Bisher beträgt die maximale Dichte der Kontaktstellen eines Grundrasters einer am Markt erhältlichen Prüfvorrichtung 62 Kontaktpunkte pro Quadratzentimeter, was einem quadratischen Raster mit einer Kantenlänge von 1,27 mm entspricht.

Es gibt zwar auch Prüfvorrichtungen am Markt mit höherer Kontaktpunktdichte (doppelte oder vierfache). Diese sind jedoch bisher technisch sehr aufwendig und daher teuer und wurden deshalb nur in sehr geringen Stückzahlen realisiert.

Bei Prüfvorrichtungen mit Grundrastern, den Paralleltestern, soll die Dichte der Kontaktpunkte des Grundrasters weiter erhöht werden. Dies macht die Herstellung derartiger Grundraster schwierig, insbesondere wenn bestimmte Kontaktstellen des Grundrasters elektrisch miteinander verbunden werden sollen. Bei den aus der EP 1 083 434 A2 bekannten Grundrasterleiterplatten ist die Produktion derart eng beieinander benachbarter Kontaktstellen auf den Schmalseitenflächen der Grundrasterleiterplatten schwierig. Bei den anderen oben erläuterten Modulen mit Grundrastern, deren Kontaktstellen elektrisch miteinander verbunden sind, ist es schwierig, die elektrische Verbindung ausgewählter Kontaktstellen zu realisieren, wenn die Dichte der Kontaktstellen weiter erhöht werden soll.

Will man die Dichte der Kontaktstellen zum Beispiel verdoppeln (64 Kontaktpunkte pro Quadratzentimeter), ist dies mit den bekannten Technologien nicht möglich. So müsste bei der Ausbildung des Grundrasters gemäß der EP 0 875 767 A2 eine Grund-rasterleiterplatte vorgesehen werden, die 48 Lagen aufweist. Eine derartige Leiter-platte kann mit heutigen Herstellungsverfahren nicht zuverlässig erzeugt werden. Es ist unmöglich, dass in einer solchen Leiterplatte alle Verbindungen korrekt ausgebildet sind. Ein fehlerhaftes Grundraster ist jedoch nicht akzeptabel in einer Prüfvorrichtung.

Ein weiteres Problem, das sich bei der Erhöhung der Dichte der Kontaktstellen eines Grundrasters ergibt, ist der zunehmende mechanische Druck, der auf dem Grundraster lastet. Der Druck ist proportional zur Anzahl der Kontaktstellen. Wenn die Kontaktstellen verdoppelt werden, erhöht sich der Druck entsprechend.

In der noch nicht veröffentlichten deutschen Patentanmeldung DE 10 2006 059 429.0 bzw. in der PCT/EP2007/062888 ist ein Modul für ein Prüfvorrichtung beschrieben, bei dem die Kontaktstellen des Grundrasters in einem Raster angeordnet sind, das aus zwei ineinander verschränkten quadratischen Rastern zusammengesetzt ist. In den quadratischen Rastern sind die Kontaktstellen jeweils etwa 1,27 mm voneinander beabstandet, wobei an jedem Eckpunkt eines Quadrates eine Kontaktstelle angeordnet ist. Im Zentrum zwischen vier an den Ecken eines Quadrates angeordneten Kontaktstellen eines Rasters ist jeweils eine Kontaktstelle des anderen quadratischen Rasters angeordnet. Diese beiden Raster sind somit um den halben Abstand zwischen zwei benachbarten Kontaktstellen eines Rasters zueinander versetzt. Dieser halbe Abstand beträgt 0,635 mm. Die Dichte der Kontaktstellen dieses Rasters beträgt ca. 124 Kontaktpunkte pro Quadratzentimeter und ist somit doppelt so hoch wie die maximale Dichte an Kontaktstellen eines Grundrasters der bisher üblichen Prüfvorrichtungen. Grundraster mit einer derart hohen Dichte von Kontaktstellen werden zum Testen von unbestückten Leiterplatten verwendet, da bei unbestückten Leiterplatten gleichzeitig eine Vielzahl von Leiterplattentestpunkten kontaktiert werden müssen. Diese hohe Dichte an Kontaktstellen wird dadurch erreicht, dass die Module jeweils eine Stützplatte und eine Kontaktplatte umfassen, wobei die Kontaktplatte aus einem starren Leiterplattenabschnitt, der als Grundrasterelement bezeichnet wird, und zumindest einem flexiblen Leiterplattenabschnitt ausgebildet ist. Am Grundrasterelement sind Kontaktstellen vorgesehen, die jeweils einen Teil der Kontaktstellen des Grundrasters bilden. Das Grundrasterelement ist quer zur jeweiligen Stützplatte an einer Stirnseite der Stützplatte angeordnet und der biegsame Leiterplattenabschnitt ist derart abgebogen, dass zumindest ein Teil des übrigen Bereichs der Kontaktplatte etwa parallel zu der Stützplatte angeordnet ist. Die Kontaktstellen des Grundrasterelementes stehen jeweils im elektrischen Kontakt mit einer in der Kontaktplatte verlaufenden Leiterbahn, die sich von dem Grundrasterelement in den flexiblen Leiterplattenabschnitt erstreckt. Mit dem flexiblen Leiterplattenabschnitt werden somit die Vielzahl von mit den Kontaktstellen verbundenen Leiterbahnen aus der Horizontalen in die Vertikale umgelenkt, wo viel Platz zur Verfügung steht.

In der noch nicht veröffentlichten DE 2007 047 269.4 ist eine Vollrasterkassette beschrieben, die Federkontaktstifte in einem Raster aufweist, das dem Grundraster der oben erläuterten DE 10 2006 059 429.0 entspricht. Die Federkontaktstifte sind jeweils aus einem Draht gewickelt und weisen keine Ummantelung auf. Die Federkontaktstifte werden in der Vollrasterkassette mittels einer Folie vertikal fixiert. Die Vollrasterkassette weist zwei Platten zum Führen der Federkontaktstifte auf, die vorzugsweise in Axialrichtung der Federkontaktstifte relativ zueinander bewegbar sind und quer zur Axialrichtung der Federkontaktstifte ein Bewegungsspiel besitzen. Weiterhin können die Federkontaktstifte mit einer zentrischen Federkontaktstelle ausgebildet sein, wobei der Draht des jeweiligen Federkontaktstiftes an der endseitigen Windung des Federkontaktstiftes mit einem geringeren Radius als die benachbarte Windung gewickelt ist.

Aus der US 4,939,454 geht ein Verbindungssystem für eine Testvorrichtung zum Testen von Leiterplatten hervor. Dieses Verbindungssystem weist Verbindungsblöcke auf, die jeweils einstückig aus Kunststoff ausgebildet sind und mit Löchern versehen sind. Die Verbindungsblöcke besitzen die Form einer lang gestreckten flachen Schiene, wobei sich die Löcher jeweils zwischen den beiden Stirnseiten erstrecken. In den Löchern ist jeweils ein Kontaktstift angeordnet. An den Verbindungsblöcken ist seitlich jeweils eine Leiterplatte befestigt. Die Kontaktstifte sind mittels Drähte elektrisch mit der Leiterplatte verbunden. Die Kontaktstifte sind Pogo-Pins. Mehrere dieser Kontaktblöcke werden nebeneinander angeordnet, sodass sie mit ihren Kontaktstiften ein Raster von Kontaktelementen ausbilden.

Der Erfindung liegt die Aufgabe zu Grunde, ein Modul für eine Prüfvorrichtung zum Testen von Leiterplatten zu schaffen, das eine entsprechend hohe Dichte der Kontaktstellen des Grundrasters erlaubt und einfach und kostengünstig herstellbar ist und im Betrieb zuverlässig ist.

Die Aufgabe wird durch ein Modul mit den Merkmalen des Anspruchs 1 gelöst. Vorteilhafte Ausgestaltungen der Erfindung sind in den Unteransprüchen angegeben.

Das erfindungsgemäße Modul für einen Paralleltester zum Prüfen von Leiterplatten weist an einer Stirnseite in einem vorbestimmten Raster Kontaktstellen auf. Diese Stirnseite wird im folgenden als Grundrasterabschnitt bezeichnet. In der Prüfvorrichtung sind mehrere Module parallel nebeneinander anordbar, so dass die Grundrasterabschnitte der Module ein ebenflächiges Grundraster ausbilden, auf dem ein Adapter und/oder Translator zum Kontaktieren einer unbestückten Leiterplatte anordbar ist.

Das Modul zeichnet sich dadurch aus, dass ein jedes Modul zumindest ein Modulelement aufweist, wobei ein Modulelement aus einer Leiterplatte und im Bereich einer Seitenkante der Leiterplatte angeordneten Kontaktstiften ausgebildet ist, wobei die Leiterplatte zwei Flachseiten aufweist, auf denen im Bereich der Seitenkante der Leiterplatte in regelmäßigen Abständen mit Leiterbahnen verbundene Kontaktfelder vorgesehen sind, an welchen jeweils einer der Kontaktstifte befestigt ist. Die Kontaktstifte sind unmittelbar auf den Flachseiten aufliegend und senkrecht zu der Seitenkante angeordnet und erstrecken sich zumindest bis zu dieser Seitenkante, so dass sie mit ihren Stirnflächen jeweils eine der Kontaktstellen des Grundrasterabschnittes bilden.

Es hat sich gezeigt, dass durch das Anordnen der Kontaktstifte aufliegend an den Flachseiten der Leiterplatte und Befestigen derselben an den Kontaktfeldern auf sehr einfache und kostengünstige Weise ein Raster an Kontaktstellen mit der gewünschten Dichte von z.B. 124 Kontaktstellen pro Quadratzentimeter geschaffen werden kann. Diese Anordnung ist aufgrund ihres einfachen Aufbaues sehr stabil und kann dauerhaft den in Prüfvorrichtungen zum Testen von unbestückten Leiterplatten auftretenden mechanischen Belastungen widerstehen.

Die Kontaktstifte stehen vorzugsweise an der angrenzenden Seitenkante der Leiterplatte vor, so dass ihre vorstehenden Abschnitte in einer Lochrasterplatte aufgenommen werden können. Die Kontaktstifte sind zylinderförmig ausgebildet und weisen vorzugsweise an ihrem an der Leiterplatte vorstehenden Abschnitt einen größeren Durchmesser als am an der Leiterplatte anliegenden Abschnitt auf. Je kleiner der Durchmesser des an der Leiterplatte anliegenden Abschnittes ist, desto höher kann die Dichte der Kontaktstellen sein.

Die Leiterplatte eines Modulelementes weist vorzugsweise die Form eines langgestreckten Streifens mit einem integral mit dem Streifen ausgebildeten Abschnitt auf, wobei sich der Abschnitt nur über einen Teil der Länge des Streifens erstreckt und an der den Kontaktstiften gegenüberliegenden Seite des Streifens angeordnet ist, und auf diesem Abschnitt, der im folgenden als Elektronikabschnitt bezeichnet wird, elektronische Bauelemente angeordnet sind, die über in der Leiterplatte ausgebildete Leiterbahnen mit den Kontaktstiften in Verbindung stehen. Durch diese Form der Leiterplatte des Modulelementes können mehrere Modulelemente eng nebeneinander liegend angeordnet sein, wobei die Elektronikabschnitte benachbarter Modulelemente, die aufgrund der elektronischen Bauteile die größte Dicke aufweisen, versetzt zueinander angeordnet sind.

Im Bereich benachbart zu den Kontaktstiften kann zumindest eine streifenförmige Metallträgerplatte angeordnet und mit der/den Moduleinheiten mechanisch fest verbunden sein, wobei die Metallträgerplatte seitlich an den Moduleinheiten vorsteht und ein Auflager bildet. Mit dieser Metallträgerplatte kann die auf das Grundraster ausgeübte mechanische Belastung seitlich auf einen Tragrahmen abgeleitet werden, so dass zumindest die Elektronikabschnitte der Modulelemente mechanisch nicht belastet werden.

Die an den Leiterplatten der Moduleinheiten vorstehenden Kontaktstifte können jeweils in einem Loch einer Lochrasterplatte angeordnet sein. Vorzugsweise stehen sie an der Lochrasterplatte ein kleines Stück vor. Bei Verwendung einer Vollrasterkassette mit nicht ummantelten Federkontaktstiften, wie sie beispielsweise in der DE 10 2007 047 269.4 beschrieben ist, besteht die Gefahr, dass bei geringen Versätzen zwischen dem Raster des Grundraster und dem Raster der Vollrasterkassette und bei einer nicht-zentrischen Anordnung der Endabschnitte der Federkontaktstifte, dass diese Kontaktstellen bzw. Kontaktstifte des Grundrasters nicht kontaktieren. Eine solche Fehlkontaktierung ist zum Einen aufgrund des Versatzes und zum Anderen dadurch möglich, dass das Grundraster und die am Grundraster anliegende Führungsplatte der Vollrasterkassette in der Regel beabstandet sind, so dass der Endabschnitt der Federkontaktstifte durch den ringförmigen Spalt zwischen der Grundrasterplatte und der Vollrasterkassette seitlich ausweichen kann. Sind die Kontaktstifte etwas von der Lochrasterplatte erhaben, dann wird der Spalt verringert und zudem werden die Federkontaktstifte näher an der jeweiligen Bohrung der Vollrasterkassette kontaktiert, so dass sie mit ihren Endabschnitten seitlich weniger weit ausweichen können.

Die Erfindung wird nachfolgend anhand der Zeichnungen näher erläutert. Die Zeichnungen zeigen beispielhaft:
- Fig. 1: einen Ausschnitt eines Modulelements mit einigen Kontaktstiften schematisch grob vereinfacht in einer Seitenansicht,
- Fig. 2: den Ausschnitt des Modulelements aus Fig. 1 in einer Ansicht von unten,
- Fig. 3: den Ausschnitt des Modulelements aus Fig. 1 in einer Seitenansicht,
- Fig. 4: einen Kontaktstift des Modulelements aus Fig. 1 in einer Seitenansicht,
- Fig. 5: ein Modulelement in grob vereinfachter Darstellung in einer Seitenansicht,
- Fig. 6: ein weiteres Modulelement in grob vereinfachter Darstellung in Seitenansicht,
- Fig. 7: vier Modulelemente, die einen Teil eines erfindungsgemäßen Moduls bilden in grob schematischer Darstellung in einer Seitenansicht,
- Fig. 8: ein Modul in grob vereinfachter Darstellung in einer Ansicht mit Blickrichtung auf eine Stirnseite,
- Fig. 9a: ein Modulelement in einer Seitenansicht,
- Fig. 9b: das Modulelement aus Fig. 9a in einer Draufsicht,
- Fig. 9c: einen Ausschnitt der in Fig. 9b gezeigten Draufsicht,
- Fig. 9d: einen Ausschnitt des Modulelementes im Bereich der Kontaktstifte in der Seitenansicht,
- Fig. 10a: ein erfindungsgemäßes Modul in der Seitenansicht,
- Fig. 10b: das Modul aus Fig. 10a in der Draufsicht mit einem Teilschnitt, und
- Fig. 10c: den in Fig. 10b teilgeschnittenen Bereich in vergrößerter Darstellung.

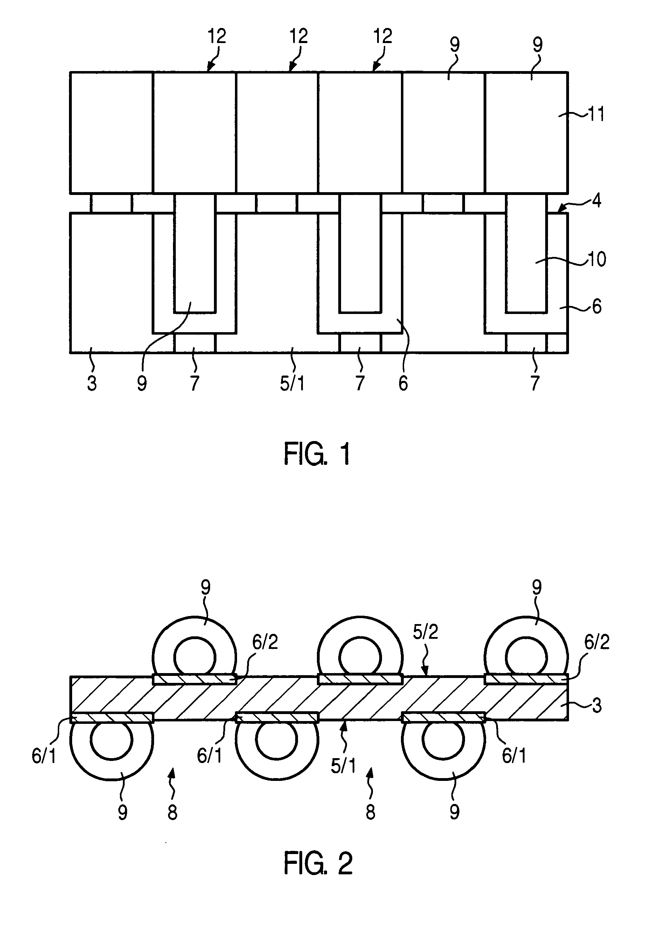

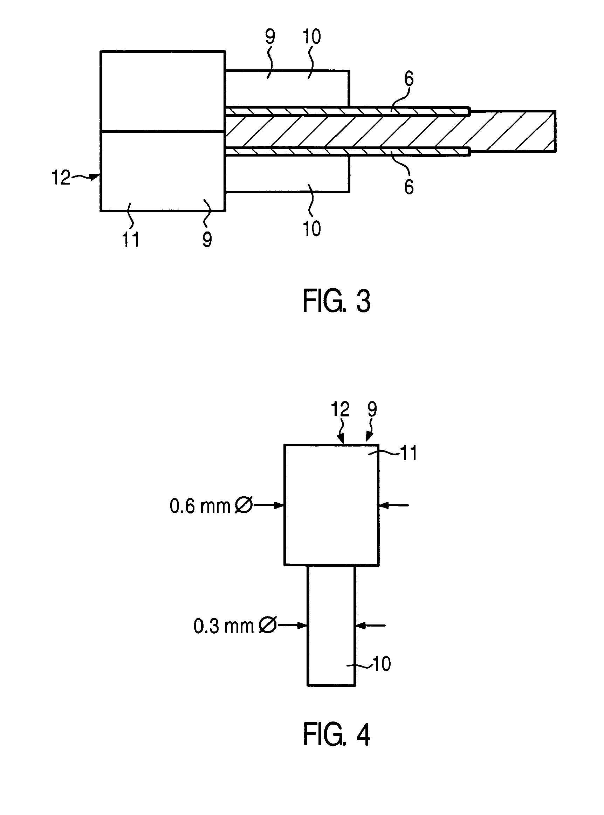

Ein Ausführungsbeispiel der vorliegenden Erfindung wird zunächst anhand der schematisch grob vereinfachten bildlichen Darstellung gemäß den Figuren 1 - 8 des Aufbaus des erfindungsgemäßen Moduls erläutert.

Ein Modul 1 ist jeweils aus mehreren Modulelementen 2 ausgebildet. Ein jedes Modulelement 2 umfasst eine Leiterplatte 3 mit zumindest einer geradlinigen, langgestreckten Seitenkante 4. Die Leiterplatte 3 ist eine eben flächige Platte mit zwei gegenüberliegenden Flachseiten 5. Im Bereich benachbart bzw. angrenzend zur Seitenkante 4 sind auf den beiden Flachseiten 5 jeweils Kontaktfelder 6 ausgebildet. Die Kontaktfelder 6 sind als Padfelder mit einem an der Oberfläche der Flachseiten 5 freiliegenden, elektrisch leitenden Material, wie zum Beispiel Kupfer oder einer speziellen Kupferlegierung ausgebildet. Die Kontaktfelder 6 sind mit in oder auf den Leiterplatten 3 verlaufenden Leiterbahnen 7 elektrisch leitend verbunden.

Die Kontaktfelder 6 sind auf den jeweiligen Flachseiten 5 im gleichen, regelmäßigen Abstand zueinander angeordnet. Die Kontaktfelder 6 sind auf den gegenüberliegenden Flachseiten 5 alternierend angeordnet, d.h., dass die Kontaktfelder 6/1 einer ersten der beiden Flachseiten 5/1 jeweils einen Zwischenbereich 8 zwischen zwei benachbarten Kontaktfeldern 6 begrenzen und dass auf der gegenüberliegenden Flachseite 5/2 die Kontaktfelder 6/2 jeweils den jeweiligen Zwischenbereichen 8 auf der ersten Flachseite 5/1 gegenüberliegen.

Auf jedem Kontaktfeld befindet sich ein Kontaktstift 9. Die Kontaktstifte 9 liegen unmittelbar auf den Kontaktfeldern 6 auf und sind jeweils senkrecht zur Seitenkante 4 ausgerichtet und liegen mit ihrer Mantelfläche auf den Kontaktfeldern 6 auf. Sie sind mit den Kontaktfeldern 6 elektrisch und mechanisch beispielsweise mittels einer Lötverbindung verbunden. Die Kontaktstifte 9 sind somit starr an den Kontaktfeldern 6 befestigt. Die Kontaktstifte 9 stehen vorzugsweise ein Stück über die Seitenkanten 4 vor. Die Kontaktstifte 9 sind wie die Kontaktfelder 6 der gegenüberliegenden Flachseiten 5/1 und 5/2 alternierend angeordnet. Anstelle der alternierenden Anordnung der Kontaktfelder 6 und der Kontaktstifte 9 ist es auch möglich, die Kontaktstifte 9 mit den jeweiligen Flachseiten 5 der Leiterplatte 3 einander paarweise gegenüberliegend anzuordnen. In einer alternativen Ausführungsform wird in einer solchen Anordnung ein Raster mit einem Rasterabstand von 0,635 mm realisiert. Vorzugsweise weisen die Kontaktstifte am an der Seitenkante 4 vorstehenden Bereich einen Abschnitt 11 mit einem größeren Durchmesser als im übrigen Abschnitt 10 der jeweiligen Kontaktstifte 9 auf.

Die Kontaktstifte 9 bilden jeweils mit ihrer an der Seitenkante 4 vorstehenden Stirnfläche 12 eine Kontaktstelle.

Im vorliegenden Ausführungsbeispiel beträgt der Abstand zweier an einer Flachseite 5 benachbarter Kontaktstifte 9 1,27 mm. Der Durchmesser der Kontaktstifte 9 beträgt im dünneren Abschnitt 10 0,3 mm. Der Durchmesser beträgt im dickeren Abschnitt 10 0,6 mm.

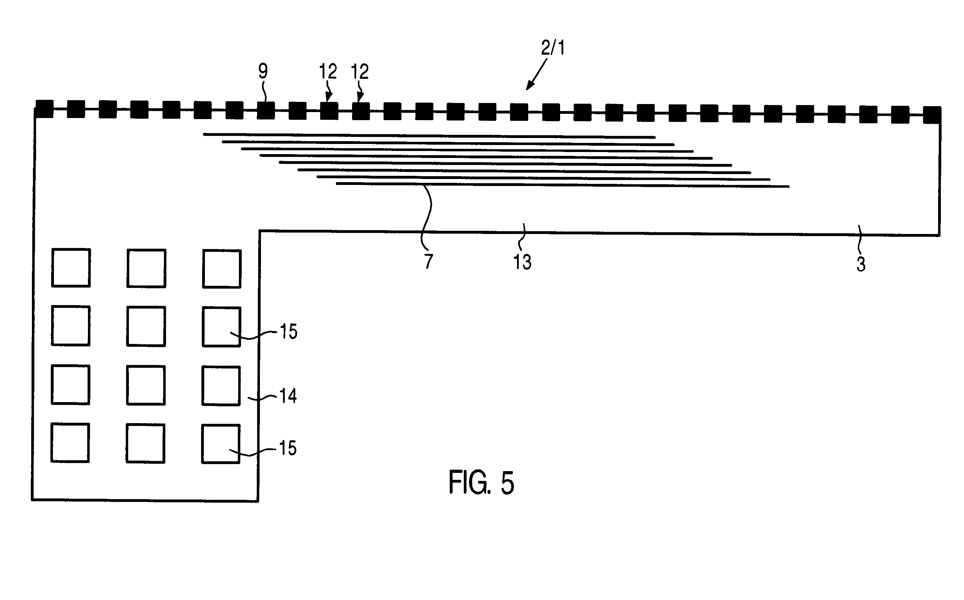

Die Leiterplatten 3 jeweils eines Modulelementes 2 sind in Form eines langgestreckten Streifens 13 mit einem integral mit dem Streifen ausgebildeten Abschnitt 14 ausgebildet, wobei sich der Abschnitt 14 nur über einen Teil der Länge des Streifens 13 erstreckt und an der den Kontaktstiften 9 gegenüberliegenden Seite des Streifens 13 angeordnet ist. Auf diesem Abschnitt 14, der im Folgenden als Elektronikabschnitt 14 bezeichnet wird, sind elektronische Bauelemente 15 angeordnet, die über die in der Leiterplatte 3 befindlichen Leiterbahnen 7 (in Fig. 5 - 7 angedeutet) mit den Kontaktstiften 9 in Verbindung stehen. Diese elektronischen Bauelemente 15 bilden eine Schaltermatrix, mit welcher eine Vielzahl von Kontaktstellen 12 auf einige wenige Ausgänge abwechselnd geschaltet werden können. Eine solche Schaltermatrix ist ausführlich in der WO 99/42850 bzw. in der korrespondierenden US 6,525,526 B1 beschrieben, auf welche vollinhaltlich Bezug genommen wird.

Im Bereich des Streifens 13 der Leiterplatte 3 sind einzelne Leiterbahnen miteinander verbunden, so dass einzelne Kontaktstellen 12 der Modulelemente elektrisch miteinander verbunden sind und gemeinsam zu den elektronischen Bauelementen 15 der Schaltermatrix geführt werden. Diese elektrische Verbindung bzw. elektrische Verknüpfung der Kontaktstellen 12 ist ähnlich ausgebildet, wie es in der WO 02/31516, EP 875 767 A2, EP 1 083 434 A2 bzw. EP 838 688 A beschrieben ist. Auf diese Dokumente wird deshalb bezüglich der Verknüpfung der Kontaktstellen 12 Bezug genommen.

Dadurch, dass die Verknüpfung der Kontaktstellen 12 mittels Leiterbahnen ausgeführt wird, welche in einer senkrecht zur Ebene der Kontaktstellen 12 verlaufenden Leiterplatte 3 angeordnet sind, bestehen keine räumlichen Beschränkungen, wie es zum Beispiel bei den Vorrichtungen nach der WO 02/31516 bzw. EP 875 767 A2 der Fall ist. Die Breite des Streifens 13 kann an sich beliebig gewählt werden, so dass beliebig viel Platz zur Verfügung steht, um die einzelnen Leiterbahnen zu verlegen und miteinander zu verknüpfen.

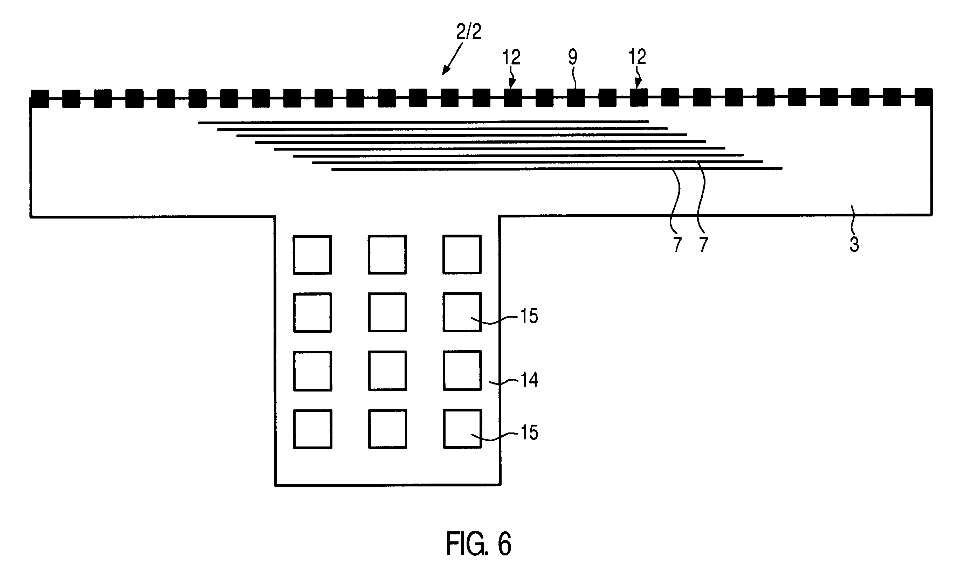

Die Elektronikabschnitte 14 sind an dem Streifen 13 der Leiterplatte 3 vorzugsweise an unterschiedlichen Stellen angeordnet. Fig. 5 zeigt beispielsweise ein Beispiel, bei dem der Elektronikabschnitt 1 endseitig an einem Streifen angeordnet ist, wohingegen Fig. 6 ein Beispiel zeigt, bei dem der Elektronikabschnitt ein Stück vom Ende des Streifens beabstandet angeordnet ist, wobei dieser Abstand vom Ende etwa der Breite eines solchen Elektronikabschnittes 14 entspricht.

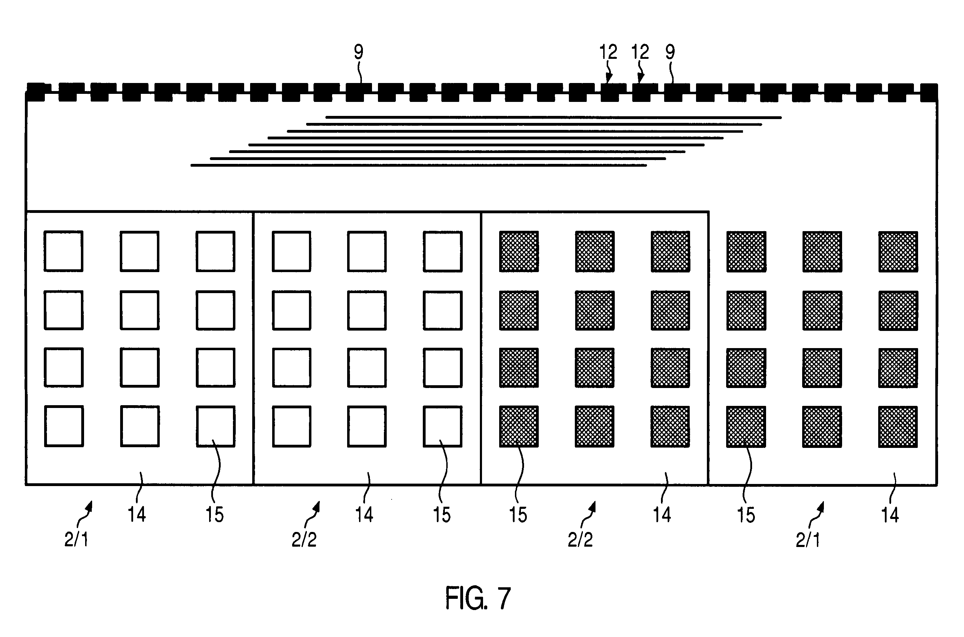

Fig. 7 zeigt, wie diese beiden Typen von Modulelementen 2/1 und 2/2 nebeneinander angeordnet werden können, wobei vier Modulelemente derart nebeneinander angeordnet werden, dass die einzelnen Elektronikabschnitte 14 räumlich zueinander versetzt sind. Hier werden zwei Modulelemente 2/1 mit jeweils endseitig angeordneten Elektronikabschnitten 14 verwendet, wobei bei der Anordnung gemäß Fig. 7 die in der linken Hälfte dargestellten Elektronikabschnitte 14 jeder Bauelemente 15 in der Bildebene von Fig. 7 oben (weiß dargestellt) und die in der rechten Hälfte von Fig. 7 angeordnete Elektronikabschnitte 14 jeweils Bauelemente 15 unterhalb der Bildebene aufweisen (schwarz dargestellt). Die Modulelemente 2/1 mit endseitigen Elektronikabschnitten 14 sind somit identisch ausgebildet. Sie sind lediglich zueinander umgekehrt angeordnet, so dass sich von einem Modulelement 2 der Elektronikabschnitt am linken Ende und vom anderen Modulelementt der Elektronikabschnitt am rechten Ende befindet. In entsprechender Weise sind die Modulelemente 2/2 mit ihren in Richtung zur Mitte versetzten Elektronikabschnitten 14 jedoch identisch ausgebildet und lediglich zueinander umgekehrt angeordnet.

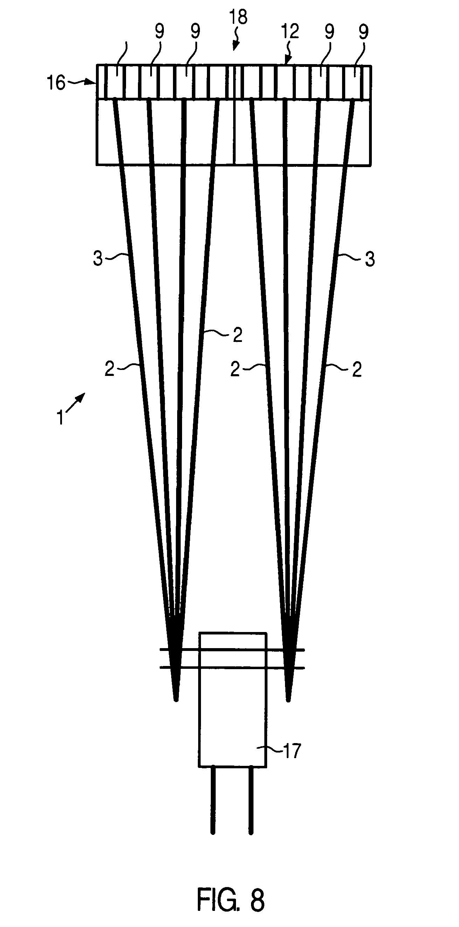

Zwei Sätze mit je vier Moduleinheiten 2 bilden ein Modul 1 (Fig. 8). Die Leiterplatten 3 können an ihren zu den Kontaktstiften 9 benachbarten Bereichen miteinander verklebt sein. Die Kontaktstifte 9 befinden sich mit ihren über den Seitenkanten 4 vorstehenden Abschnitten 11 in jeweils einem Loch einer streifenförmigen Lochrasterplatte 16. Wenn die Leiterplatten nicht miteinander verklebt sind, dann werden sie durch den Eingriff der Kontaktstifte 9 in die Löcher der Lochrasterplatte 16 zueinander räumlich fixiert.

Vorzugsweise stehen die Kontaktstifte 9 mit ihren freien Enden ein kleines Stück (z. B. 0,1 mm) an der Lochrasterplatte 16 vor. Die Elektronikabschnitte 14 sind mit ihren von den Kontaktstiften 9 entfernten Rändern mechanisch und elektrisch mit einer Steckkontaktleiste 17 verbunden, welche die Leiterbahnen von der auf die Elektronikabschnitte 14 befindlichen Schaltermatrix zu einer Auswertelektronik leitet. Die streifenförmige Lochrasterplatte 16 weist eine Breite von 10,16 mm auf. Die Kontaktstifte 9 sind in der streifenförmigen Lochrasterplatte 16 durch Reibschluss fixiert. Es kann auch zweckmäßig sein, hier ein Rastmittel vorzusehen, so dass die Kontaktstifte 9 in den Löchern der Lochrasterplatte 16 einrasten.

Dieses Modul 1 bildet somit an seiner Stirnseite 18 eine Anordnung von Kontaktstellen 12 in einem Raster, das aus zwei ineinander verschränkten quadratischen Rastern zusammengesetzt ist. In den quadratischen Rastern sind die Kontaktstellen jeweils etwa 1,27 mm voneinander beabstandet, wobei in jedem Eckpunkt eines Quadrates eine Kontaktstelle angeordnet ist. Im Zentrum zwischen vier an den Ecken des Quadrates angeordneten Kontaktstellen eines Rasters ist jeweils eine Kontaktstelle des anderen quadratischen Rasters angeordnet. Diese beiden Raster sind somit im halben Abstand zwischen zwei benachbarten Kontaktstellen eines Rasters zueinander versetzt. Dieser halbe Abstand beträgt 0,635 mm. Die Dichte der Kontaktstellen dieses Rasters beträgt ca. 124 Kontaktpunkte pro cm². Diese Stirnseite 18 des Moduls 1 wird im Folgenden als Grundrasterabschnitt 18 bezeichnet.

In einem Paralleltester zum Prüfen von Leiterplatten sind mehrere dieser Module nebeneinander liegend angeordnet, wobei sie mit den Grundrasterabschnitten 18 angrenzend zueinander in einer Ebene angeordnet sind und so ein ebenflächiges Grundraster bilden. In Prüfvorrichtungen zum zweiseitigen Testen von Leiterplatten werden jeweils zwei Sätze von Modulen einander gegenüberliegend angeordnet, wobei die Grundrasterabschnitte bzw. die Grundraster zueinander weisend ausgebildet sind, so dass zwischen zwei Grundrastern mittels entsprechender Adapter eine zu testende Leiterplatte aufgenommen und kontaktiert werden kann.

Im obigen Ausführungsbeispiel ist eine streifenförmige Lochrasterplatte 16 für jeweils einen Satz von vier Modulelementen 2 vorgesehen. Im Rahmen der Erfindung ist es selbstverständlich auch möglich, eine Lochrasterplatte zu verwenden, die sich über die gesamte Fläche des Grundrasters des Paralleltesters erstreckt, wobei die Module mit ihren vorstehenden Kontaktstiften dann in die Lochrasterplatte eingesetzt werden. Bei dieser Ausführungsform ist somit die Lochrasterplatte kein Bestandteil des Moduls.

Im Rahmen der Erfindung ist es selbstverständlich auch möglich, andere Rasterabstände und andere Rasteranordnungen vorzusehen.

Ein wesentlicher Vorteil der erfindungsgemäßen Module ist der einfache und stabile Aufbau. Zum einen können die Kontaktstifte einfach und kostengünstig an den relativ großflächigen Kontaktfeldern 6 elektrisch und mechanisch befestigt werden. Zum anderen bietet die zum Grundraster senkrechte Anordnung der Leiterplatten 3 eine große Fläche zum Führen der Leiterbahnen, wodurch an sich beliebige komplexe Schaltungen und elektrische Verknüpfungen ausgeführt werden können. Weiterhin ist von Vorteil, dass die Leiterplatten eines jeden Modulelementes mehrlagig ausgebildet sein können und vorzugsweise vierlagig ausgebildet sind. Hierdurch können relativ komplexe Schaltungsstrukturen bereits innerhalb der Leiterplatte geschaffen werden. Das Vorsehen mehrerer Leiterplatten innerhalb eines Moduls erhöht die Möglichkeiten der Schaltungsführung erheblich. Würde man vier Modulelemente durch eine einzige Leiterplatte ersetzen, so müsste diese zum Erreichen der gleichen Möglichkeiten für die Leitungsführung 16-lagig ausgeführt sein, was zum einen sehr teuer ist und zum anderen sehr viel anfälliger ist.

Ein weiterer Vorteil liegt darin, dass die Kontaktstifte des vorliegenden Ausführungsbeispiels ein Massenprodukt sind, da derartige Kontaktstifte herkömmlicherweise für Steckverbinder verwendet werden. Sie sind deshalb in hoher Qualität und Präzision sehr günstig erhältlich.

Dieses Modul ist somit im Vergleich zu herkömmlichen Modulen, die eine hohe Dichte an Kontaktstellen bereitstellen, wesentlich günstiger herstellbar und zudem aufgrund der einfachen mechanischen und elektrischen Anbringung der Kontaktstifte zuverlässig.

Auf jeder Seite der Leiterplatte 3 eines Modulelementes 2 ist vorzugsweise eine Metallträgerplatte 19 befestigt, die sich an beiden Rändern der Leiterplatte 3 ein gutes Stück über den Bereich des Grundrasterabschnitts hinaus erstreckt und seitlich vorstehende Laschen 20 bilden, die als Auflager dienen. Die Metallträgerplatten 19 sind streifenförmig ausgebildet, wobei deren Breite geringer als die Breite des Streifens 13 der Leiterplatten 3 sein kann. Im Paralleltester liegen die Laschen 20 auf einem Tragrahmen auf, so dass die auf die Grundrasterabschnitte ausgeübte mechanische Belastung über die Laschen auf den Tragrahmen abgeleitet wird. Der Bereich der Leiterplatten 3, der sich unterhalb der Metallträgerplatten 19 befindet, ist somit frei von mechanischer Belastung.

Die Metallträgerplatten weisen vorzugsweise eine Stärke von 0,4 mm auf und sind flächig mit den jeweiligen Leiterplatten 3 verklebt. Hierdurch wird der korrekte Abstand zwischen benachbarten Modulelementen zur Erzielung des Rasters der Kontaktstellen 12 für das Grundraster erhalten. Beim Auftragen der Klebeschicht ist darauf zu achten, dass der Bereich der Kontaktstifte 9 frei von Kleber bleibt.

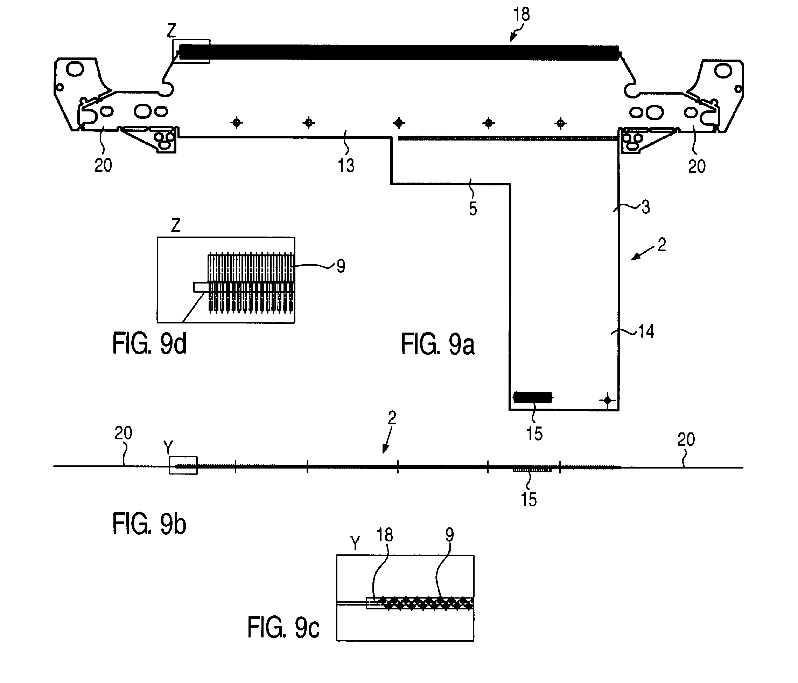

In Fig. 9a bis 9d ist ein Modulelement 2 dargestellt, wie es in einem Prototypen ausgeführt ist. Wobei bei dem in Fig. 9a bis 9d gezeigten Modulelement noch keine Metallträgerplatte 19 auf die Leiterplatte aufgebracht ist.

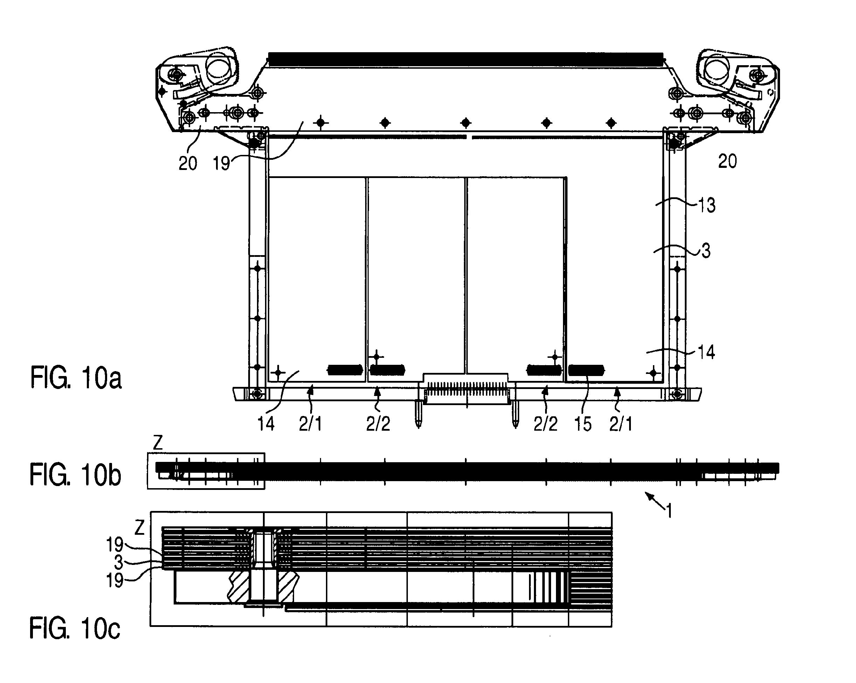

Die Figuren 10a bis 10c zeigen ein Modul 1, das aus acht Modulelementen 2 ausgebildet ist. Die Metallträgerplatten 19 sind hierbei im Bereich unterhalb der Kontaktstifte 9 flächig mit den Leiterplatten 3 verklebt und verschraubt. Im Bereich der Laschen 20 erstrecken sich sowohl die Leiterplatten 3 als auch die Metallträgerplatten 19 und bilden eine steife Verbundstruktur.

Die Module können mit hoher Präzision hergestellt werden, so dass sie ohne Nachjustierung in eine Prüfvorrichtung einsetzbar sind. Sie genügen allen elektrischen und mechanischen Anforderungen, um großflächige unbestückte Leiterplatten mit hohem Durchsatz zu testen.

### Bezugszeichenliste

- 1: Modul
- 2: Modulelement
- 3: Leiterplatte
- 4: Seitenkante
- 5: Flachseite
- 6: Kontaktfeld
- 7: Leiterbahn
- 8: Zwischenbereich
- 9: Kontaktstift
- 10: Abschnitt
- 11: Abschnitt
- 12: Stirnfläche vom Kontaktstift 9 bzw. Kontaktstelle
- 13: Streifen
- 14: Elektronikabschnitt
- 15: Bauelement
- 16: Lochrasterplatte
- 17: Steckkontaktleiste
- 18: Stirnseite
- 19: Metallträgerplatte
- 20: Lasche

## Patentansprüche

1. Modul für einen Paralleltester zum Prüfen von Leiterplatten, wobei das Modul (1) eine Stirnseite aufweist, an der in einem vorbestimmten Raster Kontaktstellen angeordnet sind, und diese Stirnseite (18) im folgenden als Grundrasterabschnitt (18) bezeichnet wird, wobei in einem Paralleltester mehrere Module (1) parallel nebeneinander anordbar sind, so dass die Grundrasterabschnitte (18) der Module (1) ein ebenflächiges Grundraster ausbilden, auf dem ein Adapter und/oder Translator zum Kontaktieren einer unbestückten Leiterplatte anordbar ist,
wobei das Modul (1) zumindest ein Modulelement (2) aufweist, wobei ein Modulelement (2) aus einer Leiterplatte (3) und im Bereich einer Seitenkante (4) der Leiterplatte (3) angeordneten Kontaktstiften (9) ausgebildet ist, wobei die Leiterplatte (3) zwei Flachseiten (5) aufweist, auf denen im Bereich der Seitenkante (4) der Leiterplatte (3) in regelmäßigen Abständen mit Leiterbahnen (7) verbundene Kontaktfelder (6) vorgesehen sind, an welchen jeweils einer der Kontaktstifte (9) befestigt ist, wobei die Kontaktstifte (9) senkrecht zu der Seitenkante (4) angeordnet sind und sich zumindest bis zu dieser Seitenkante (4) erstrecken, so dass sie mit ihren Stirnflächen (12) jeweils eine der Kontaktstellen (12) des Grundrasterabschnittes (18) bilden **dadurch gekennzeichnet, dass** die kontaktstifte (9) auf den Flachseiten (5) aufliegend angeordnet sind.

2. Modul nach Anspruch 1,
**dadurch gekennzeichnet,**
**dass** die Kontaktstifte (9) an der angrenzenden Seitenkante (4) der Leiterplatte (3) vorstehen.

3. Modul nach Anspruch 2,
**dadurch gekennzeichnet,**
**dass** die Kontaktstifte (9) zylinderförmig ausgebildet sind und an ihrem an der Leiterplatte (3) vorstehenden Abschnitt (11) einen größeren Durchmesser als am an der Leiterplatte anliegenden Abschnitt (10) aufweisen.

4. Modul nach einem der Ansprüche 1 bis 3,
**dadurch gekennzeichnet,**
**dass** die die Kontaktstifte (9) der gegenüberliegenden Flachseiten (5) der Leiterplatte (3) eines Modulelementes (2) alternierend angeordnet sind.

5. Modul nach einem der Ansprüche 1 bis 4,
**dadurch gekennzeichnet,**
**dass** das Modul (1) mehrere Modulelemente (2) umfasst.

6. Modul nach einem der Ansprüche 1 bis 5,
**dadurch gekennzeichnet,**
**dass** die Leiterplatte (3) eines Modulelementes (2) die Form eines langgestreckten Streifens (13) mit einem integral mit dem Streifen ausgebildeten Abschnitt (14) aufweist, wobei sich der Abschnitt (14) nur über einen Teil der Länge des Streifens (13) erstreckt und an der den Kontaktstiften (9) gegenüberliegenden Seite des Streifens (13) angeordnet ist, und auf diesem Abschnitt (14), der im folgenden als Elektronikabschnitt (14) bezeichnet wird, elektronische Bauelemente (15) angeordnet sind, die über in der Leiterplatte (3) ausgebildete Leiterbahnen (7) mit den Kontaktstiften (9) in Verbindung stehen.

7. Modul nach Anspruch 6,
**dadurch gekennzeichnet,**
**dass** die Modulelemente (2) des Moduls (1) mit zueinander räumlich versetzt angeordneten Elektronikabschnitten (14) ausgebildet sind.

8. Modul nach einem der Ansprüche 1 bis 7,
**dadurch gekennzeichnet,**
**dass** die Leiterplatte (3) des Modulelements (2) als mehrlagige Leiterplatte, insbesondere 4-lagige Leiterplatte, ausgebildet ist.

9. Modul nach einem der Ansprüche 1 bis 8,
**dadurch gekennzeichnet,**
**dass** im Bereich benachbart zu den Kontaktstiften (9) zumindest eine streifenförmige Metallträgerplatte (19) angeordnet und mit der/den Modulelementen (2) mechanisch fest verbunden ist, wobei die Metallträgerplatte (19) seitlich an den Modulelementen (2) vorsteht und ein Auflager bildet.

10. Modul nach Anspruch 9,
**dadurch gekennzeichnet,**
**dass** an einer jeden Leiterplatte (3) eines Modulelementes (2) eine Metallträgerplatte (19) angeordnet ist, wobei die jeweilige Leiterplatte (3) und die Metallträgerplatte (19) vorzugsweise miteinander verklebt sind.

11. Modul nach einem der Ansprüche 1 bis 10,
**dadurch gekennzeichnet,**
**dass** das Modul (1) an seiner Stirnseite (18) eine streifenförmige Lochrasterplatte (16) mit in einem vorbestimmten Raster angeordneten Löchern aufweist, wobei in jeweils einem Loch einer der Kontaktstifte (9) formschlüssig lagert, und dass die Kontaktstifte (9) sich durch die Lochrasterplatte (16) hindurch erstrecken und mit ihren freien Enden ein Stück an der Lochrasterplatte (16) vorstehen.

12. Modul nach einem der Ansprüche 1 bis 10,
**dadurch gekennzeichnet,**
**dass** bestimmte Kontaktstifte (9) mittels der in der Leiterplatte (3) der Modulelemente (2) verlaufenden Leiterbahnen elektrisch miteinander verbunden sind.

13. Modul nach Anspruch 6 oder Anspruch 6 und einem der Ansprüche 7 bis 11,
**dadurch gekennzeichnet,**
**dass** das Modul (1) acht Modulelemente (2) umfasst, wobei die Modulelemente (2) einen ersten und einen zweiten Typ von Leiterplatten (3) aufweisen, wobei der erste Typ von Leiterplatten (3) den Elektronikabschnitt (14) am seitlichen Rand aufweist und der zweite Typ von Leiterplatte (3) einen vom seitlichen Rand beabstandet angeordneten Elektronikabschnitt (14) aufweist, und jeweils vier Modulelemente (2) nebeneinander derart angeordnet sind, dass alle Elektronikabschnitte (14) der vier Modulelemente (2) zueinander versetzt sind.

14. Paralleltester zum Prüfen von Leiterplatten,
**dadurch gekennzeichnet,**
**dass** der Paralleltester ein Grundraster aufweist, das aus mehreren Modulen (1) nach einem der Ansprüche 1 bis 10 oder 12 gebildet ist.

15. Paralleltester nach Anspruch 14,
**dadurch gekennzeichnet,**
**dass** die Kontaktstifte (9) in einer Lochrasterplatte lagern, die sich über das gesamte Grundraster erstreckt.

## Claims

1. Module for a parallel tester for the testing of circuit boards, wherein the module (1) has an end face on which contact points are arranged in a predetermined grid, and this end face (18) is hereafter described as the basic grid section (18), wherein in a parallel tester several modules (1) are arranged in parallel alongside one another, so that the basic grid sections (18) of the modules (1) form a flat-surfaced basic grid on which an adapter and/or translator may be arranged for the contacting of a non-componented circuit board ,
**wherein** the module (1) has at least one module element (2), with a module element (2) being formed of a circuit board (3) and contact pins (9) arranged in the area of a side edge (4) of the circuit board (3), wherein the circuit board (3) has two flat sides (5) on which are provided, in the area of the side edge (4) of the circuit board (3) at regular intervals, contact fields (6) connected to conductor paths (7) and to which in each case one of the contact pins (9) is attached, wherein the contact pins (9) at right-angles to the side edge (4) and extend at least up to this side edge (4), so that they form with their end faces (12) in each case one of the contact points (12) of the basic grid section (18),
**characterised in that**
the contact pins (9) are arranged lying on the flat sides (5)

2. Module according to claim 1
**characterised in that**
the contact pins (9) protrude at the adjacent side edge (4) of the circuit board (3).

3. Module according to claim 2
**characterised in that**
the contact pins (9) are cylindrical in shape and, at their section (11) protruding from the circuit board (3), have a greater diameter than at their section (10) lying on the circuit board.

4. Module according to any of claims 1 to 3
**characterised in that**
the contact pins (9) of the opposite flat sides (5) of the circuit board (3) of a module element (2) are arranged alternately.

5. Module according to any of claims 1 to 4
**characterised in that**
the module (1) comprises several module elements (2).

6. Module according to any of claims 1 to 5
**characterised in that**
the circuit board (3) of a module element (2) has the form of an elongated strip (13) with a section (14) which is integral with the strip, wherein the section (14) extends over only part of the length of the strip (13) and is mounted on the side of the strip (13) opposite the contact pins (9), and provided on this section (14), hereafter described as the electronics section (14), are electronic components (15) which are in contact with the contact pins (9) via conductor paths (7) formed in the circuit board (3).

7. Module according to claim 6
**characterised in that**
the module elements (2) of the module (1) are designed with electronics sections (14) offset from one another.

8. Module according to any of claims 1 to 7
**characterised in that**
the circuit board (3) of the module element (2) is designed as a multi-layer circuit board, in particular a 4-layer circuit board.

9. Module according to any of claims 1 to 8
**characterised in that**
in the area adjacent to the contact pins (9) at least one strip-shaped metal support plate (19) is provided and firmly connected physically to the module element or elements (2), wherein the metal support plate (19) protrudes from the side of the module elements (2) and forms a support.

10. Module according to claim 9
**characterised in that**
each circuit board (3) of a module element (2) is provided with a metal support plate (19), wherein the respective circuit board (3) and the metal support plate (19) are preferably bonded together.

11. Module according to any of claims 1 to 10
**characterised in that**
the module (1) has on its end face (18) a strip-shaped perforated grid board (16) with holes arranged in a predetermined grid, wherein one of the contact pins (9) is positively supported in each hole, and that the contact pins (9) extend through the perforated grid board (16) and with their free ends protrude a short distance beyond the perforated grid board (16).

12. Module according to any of claims 1 to 10
**characterised in that**
certain contact pins (9) are electrically connected to one another by means of conductor paths running in the circuit board (3) of the module elements (2).

13. Module according to claim 6 or claim 6 and any of claims 7 to 11
**characterised in that**
the module (1) comprises eight module elements (2), wherein the module elements (2) have a first and a second type of circuit board (3), wherein the first type of circuit board (3) has the electronics section (14) at the side edge, and the second type of circuit board (3) has an electronics section (14) located with clearance from the side edge, and in each case four module elements (2) are mounted alongside one another in such a way that all electronics sections (14) of the four module elements (2) are offset from one another.

14. Parallel tester for the testing of circuit boards
**characterised in that**
the parallel tester has a basic grid formed of several modules (1) according to any of claims 1 to 10 or 12.

15. Parallel tester according to claim 14
**characterised in that**
the contact pins (9) rest in a perforated grid board which extends over the whole of the basic grid.

## Revendications

1. Module pour un testeur parallèle destiné à contrôler des cartes à circuits imprimés, ledit module (1) présentant une face frontale sur laquelle sont agencés des points de contact suivant une trame prédéterminée, et ladite face frontale (18) est désignée dans ce qui suit par "tronçon de trame de base" (18), de sorte que plusieurs modules (1) sont susceptibles d'être agencés les uns à côté des autres dans un testeur parallèle de telle façon que les tronçons de trame de base (18) des modules (1) constituent une trame de base plane sur laquelle un adaptateur et/ou un convertisseur est susceptible d'être agencé pour la mise en contact avec une carte à circuits imprimés non garnie, dans lequel le module (1) comprend au moins un élément de module (2), de sorte qu'un élément de module (2) est constitué d'une carte à circuits imprimés (3) et de tiges de contact (9) agencées dans la zone d'une arête latérale (4) de la carte à circuits imprimés (3), ladite carte à circuits imprimés (3) comportant deux côtés plats (5) sur lesquels sont prévus des ressorts de contact (6) sur chacun desquels est fixée respectivement l'une des tiges de contact (9), lesdites tiges de contact (9) étant agencées perpendiculairement à l'arête latérale (4) et s'étendant au moins jusqu'à ladite arête latérale, de sorte qu'elles forment, avec leurs faces frontales (12) chacune l'un des points de contact (12) du tronçon de trame de base (18),
**caractérisé en ce que**
les tiges de contact (9) sont agencées en étant appliquées sur les côtés plats (5).

2. Module selon la revendication 1,
**caractérisé en ce que** les tiges de contact (9) dépassent au niveau de l'arête latérale adjacente (4) de la carte à circuits imprimés (3).

3. Module selon la revendication 2,
**caractérisé en ce que** les tiges de contact (9) sont réalisées sous forme cylindrique et présentent, au niveau de leur tronçon (11) qui dépasse de la carte à circuits imprimés (3) un plus grand diamètre qu'au niveau du tronçon (10) appliqué contre la carte à circuits imprimés.

4. Module selon l'une des revendications 1 à 3,
**caractérisé en ce que** les tiges de contact (9) des côtés plats opposés (5) de la carte à circuits imprimés (3) d'un élément de module (2) sont agencées en alternance.

5. Module selon l'une des revendications 1 à 4,
**caractérisé en ce que** le module (1) comprend plusieurs éléments de module (2).

6. Module selon l'une des revendications 1 à 5,
**caractérisé en ce que** la carte à circuits imprimés (3) d'un élément de module (2) présente la forme d'un ruban allongé (13) avec un tronçon (14) réalisé de manière intégrale avec le ruban, de sorte que le tronçon (14) s'étend seulement sur une partie de la longueur du ruban (13) et est agencé du côté du ruban (13) opposé aux tiges de contact (9) et sur ce tronçon (14), désigné dans ce qui suit comme "tronçon électronique" (14), sont agencés des composants électroniques (15) qui sont connectés avec les tiges de contact (9) via des pistes conductrices (9) réalisées dans la carte à circuits imprimés (3).

7. Module selon la revendication 6,
**caractérisé en ce que** les éléments de module (2) du module (1) sont réalisés avec des tronçons électroniques (14) agencés de façon décalée dans l'espace les uns par rapport aux autres.

8. Module selon l'une des revendications 1 à 7,
**caractérisé en ce que** la carte à circuits imprimés (3) de l'élément de module (2) est réalisée sous forme d'une carte à circuits imprimés multicouches, en particulier d'une carte à circuits imprimés à quatre couches.

9. Module selon l'une des revendications 1 à 8,
**caractérisé en ce qu'**au moins une plaque porteuse métallique (19) en forme de bande est agencée dans la région voisine des tiges de contact (9) et est fermement reliée mécaniquement avec le/les élément(s) de module (2), ladite plaque porteuse métallique (9) dépassant latéralement sur les éléments de module (2) et formant un support.

10. Module selon la revendication 9,
**caractérisé en ce qu'**une plaque porteuse métallique (19) est agencée sur chacune des cartes à circuits imprimés (9) d'un élément de module (2), et la carte à circuits imprimés respective (3) et la plaque porteuse métallique (19) sont de préférence collées l'une à l'autre.

11. Module selon l'une des revendications 1 à 10,
**caractérisé en ce que** le module (1) comporte au niveau de sa face frontale (18) une plaque à trous tramée (16) en forme de bande avec des trous agencés suivant une trame prédéterminée, l'une des tiges de contact (9) étant disposée respectivement dans un trou en coopération de formes, et **en ce que** les tiges de contact (9) s'étendent à travers la plaque à trous tramée (16) et dépassent à leurs extrémités libres d'une petite distance sur la plaque à trous tramée (16).

12. Module selon l'une des revendications 1 à 10,
**caractérisé en ce que** certaines tiges de contact (9) sont connectées électriquement les unes aux autres au moyen de pistes conductrices qui s'étendent dans la carte à circuits imprimés (9) des éléments de module (2).

13. Module selon la revendication 6 ou selon la revendication 6 et l'une des revendications 7 à 11,
**caractérisé en ce que** le module (1) comprend huit éléments de module (2), lesdits éléments de module (2) comprenant des cartes à circuits imprimés (3) d'un premier et d'un second type, le premier type de carte à circuits imprimés (3) comportant le tronçon électronique (14) au niveau de la bordure latérale, et le second type de carte à circuits imprimés (3) comportant un tronçon électronique (14) agencé en écartement de la bordure latérale, et quatre éléments de module (2) sont agencés respectivement les uns à côté des autres de telle façon que tous les tronçons électroniques (14) des quatre éléments de module (2) sont décalés les uns par rapport aux autres.

14. Testeur parallèle pour contrôler des cartes à circuits imprimés,
**caractérisé en ce que** le testeur parallèle comporte une trame de base qui est formée de plusieurs modules (1) selon l'une des revendications 1 à 10 ou 12.

15. Testeur parallèle selon la revendication 14,
**caractérisé en ce que** les tiges de contact (9) sont logées dans une plaque à trous tramée qui s'étend sur la totalité de la trame de base.
